# EUROPÄISCHE PATENTANMELDUNG

(11) **EP 1 148 510 A2**
(43) Veröffentlichungstag der Anmeldung: **24.10.2001**
(21) Anmeldenummer: 01107398.8
(22) Anmeldetag: 26.03.2001
(51) Int. Cl.: G11C 7/10

(54) **Integrierte Halbleiterschaltung, insbesondere Halbleiterspeicheranordnung und Verfahren zum Betrieb derselben**

(30) Priorität: 11.04.2000 DE 10018013
(71) Anmelder: Infineon Technologies AG, 81669 München (DE)
(72) Erfinder: Müller, Jochen, Dr., 81825 München (DE)
(74) Vertreter: MÜLLER & HOFFMANN Patentanwälte

(57) **Zusammenfassung**

Die Erfindung betrifft eine integrierte Halbleiterschaltung, insbesondere Halbleiterspeicheranordnung, die in verschiedenen Betriebsmodi betreibbar ist, und die eine Vorrichtung zum Umschalten zwischen diesen Betriebsmodi aufweist, und ist dadurch gekennzeichnet, dass die Umschaltvorrichtung mindestens eine von außen durchtrennbare und programmierbare Fuseeinheit in der integrierten Halbleiterschaltung aufweist.

## Beschreibung

Die vorliegende Erfindung betrifft eine integrierte Halbleiterschaltung, insbesondere eine Halbleiterspeicheranordnung, die in verschiedenen Betriebsmodi betrieben werden kann, und die dazu eine Vorrichtung zum Umschalten zwischen diesen Betriebsmodi aufweist, sowie ein Verfahren zum Betrieb einer integrierten Halbleiterspeicheranordnung.

Allgemein werden integrierte Halbleiterschaltungen, insbesondere integrierte Halbleiterspeicheranordnungen, mit einem oder mehreren zusätzlichen Pads versehen, um auf Waferebene zuverlässig zwischen verschiedenen Betriebs- oder Testmodi wechseln zu können. Wird dann ein solches zusätzliches Pad auf einen vorbestimmten Spannungswert von außen gezogen, so wechselt die integrierte Halbleiterschaltung in einen anderen Betriebsmodus. Mit x-Pads kann zwischen 2^{x}-Modi gewechselt werden.

Zum Beispiel versteht man bei einer integrierten Halbleiterspeicheranordnung unter den verschiedenen Betriebsmodi zum einen den "normalen" Betriebsmodus, wie ihn auch der Anwender verwendet, und zum anderen andere, nicht normale Betriebsmodi, bei denen z. B. die Funktionalität des Interfaces verändert wird, sowie Modi, die die Bedingungen, unter denen der Speicherchip betrieben wird, verändern und die allgemein Testmodi genannt werden. Solche verschiedenen Modi sind z. B. "RAMBUS": Normaler Betriebsmodus, DA MODE und Drowsy Mode.

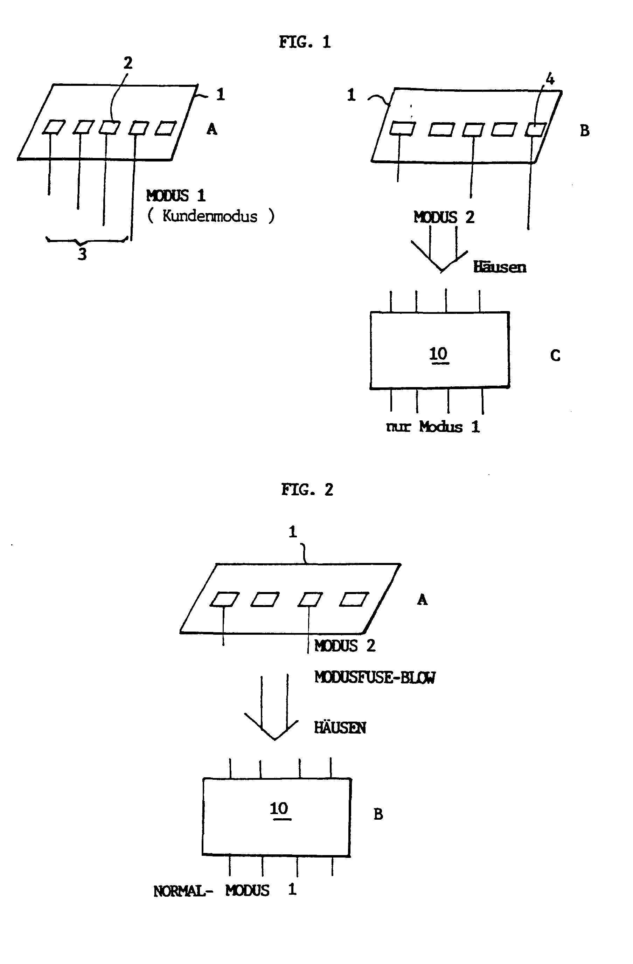

Die beiliegende Fig. 1 zeigt in ihrem Teil A schematisch einen Chip 1 auf Waferebene mit verschiedenen Pads 2 und zugehörigen Kontaktoren 3. Der Chip 1 befindet sich in unkontaktiertem Zustand der entsprechenden Pads in einem Kundenmodus, der hier beispielhaft Modus 1 genannt ist.

Im Teil B der Fig. 1 ist der Chip 1 durch Ansteuerung des Moduspads 4 in den Modus 2 gebracht worden. Nach dem Häusen, wenn der Chip dann als Baustein 10 vorliegt (Fig. 1C), ist nur Modus 1 möglich.

Die Notwendigkeit eines solchen zusätzlichen Moduspads kann sich daraus ergeben, dass ein Speicherchip auf Waferebene mit einer veränderten Funktionalität des Interfaces betrieben werden soll, wobei für die Modi mit unterschiedlichen Funktionalitäten des Interfaces verschiedene Kontaktoren, im allgemeinen Nadelkarten, verwendet werden. Wenn nun eine dieser Nadelkarten nicht alle Pads kontaktiert, die nötig sind, den Chip durch eine von außen angelegte Kombination von Signalen an den Pads in den anderen Modus zu bringen, so lässt sich dies dennoch durch Ziehen des zusätzlichen Pads auf die entsprechende Spannung erreichen.

Ein solches zusätzliches Pad ist im Chip nicht mit den Gehäusekontakten verbunden. Damit wird vermieden, dass ein Anwender irrtümlicherweise in einen anderen Betriebsmodus wechselt.

Es ist Aufgabe der Erfindung, den zusätzlichen Pad oder die zusätzlichen Pads einer integrierten Halbleiterschaltung, insbesondere Halbleiterspeicheranordnung, zu vermeiden und eine zuverlässige Umschaltung zwischen verschiedenen Betriebs- oder Testmodi bei solchen integrierten Halbleiterschaltungen, insbesondere Halbleiterspeicheranordnungen, zu ermöglichen.

Gemäß einem wesentlichen Aspekt der Erfindung weist eine die obige Aufgabe lösende integrierte Halbleiterschaltung, insbesondere Halbleiterspeicheranordnung, die in verschiedenen Betriebsmodi betreibbar ist, eine Vorrichtung zum Umschalten zwischen diesen Betriebsmodi auf, wobei die Umschaltvorrichtung mindestens eine wenigstens im gehäusten Zustand der Halbleiterschaltung durchtrennbare Fuseeinheit aufweist und ist dadurch gekennzeichnet, dass die Fuseeinheit eine durch "Fuse Soft Set" programmierbare Fuseeinheit ist, die auch auf Waferebene der integrierten Halbleiterschaltung durchtrennbar ist und bei der durch programmiertes Fuse Soft Set der durchtrennte Zustand überbrückbar ist.

Durch die Verwendung der programmierbaren Betriebsmodusfuse muss kein zusätzliches Pad zum Wechseln zwischen den verschiedenen Betriebsmodi mehr vorhanden sein. Um den Chip vor dem Einschließen in ein Gehäuse in den normalen Betriebsmodus zu bringen, wird die Betriebsmodusfuse durchtrennt, d. h., sie wird geschossen.

Da die Betriebsmodusfuse auch programmiert werden kann ("Fuse Soft Set"), ist es möglich, auch im gehäusten Baustein zwischen den Modi zu wechseln.

Üblicherweise wird die Information der Fuse (durchtrennt bzw. geschossen oder nicht) nach dem Hochfahren der externen Versorgungsspannung nur einmal ausgelesen, so dass der Speicherchip in dem jeweils gesetzten Betriebsmodus bleibt, so lange die externe Spannung anliegt. Damit der Chip z. B. auch unmittelbar nach der Fertigung noch vor der Durchtrennung einer Fuseeinheit mit einer Nadelkarte gemessen werden kann, die auf die Funktionalität des Interfaces des nicht normalen Betriebsmodus basiert, kann die mit der Umschaltvorrichtung in Verbindung stehende Betriebsmodusauswahlschaltung, die entscheidet, in welchem Betriebsmodus sich der Chip nach dem Hochfahren der Versorgungsspannung befindet, automatisch den anderen als den normalen Betriebsmodus auswählen. Die Auswahl des Betriebsmodus nach dem Hochfahren der Versorgungsspannung kann mit der programmierbaren Fuseeinheit, muss aber nicht notwendigerweise mit der programmierbaren Fuseeinheit verbunden sein.

Fig. 2 zeigt ebenfalls schematisch eine Möglichkeit, zwischen verschiedenen Modi umzuschalten, ohne dass ein Moduspad vorhanden ist. Im Teil A der Fig. 2, wo der Chip 1 auf Waferebene vorliegt, kann z.B. durch Ansteuerung entsprechender Kontaktoren, d.h. der Nadelkarten, ein gegenüber dem normalen Modus veränderter Betriebsmodus, z.B. der Modus 2, gewählt werden. In Fig. 2B, wo der Chip im gehäusten Zustand, d.h. als Baustein 10, vorliegt, wurde vor dem Häusen die Modusfuse geschossen (Modusfuse-Blow), so dass der Baustein 10 dann im normalen Modus, z.B. Modus 1 betrieben wird.

Die erfindungsgemäße Anordnung läßt jedoch auch im gehäusten Zustand einen Wechsel zwischen Modus 1 und 2 durch Fuse-soft-set zu. Dies gilt selbstverständlich auch für die in Fig. 2A gezeigte Waferebene des Chips 1.

Nachstehend wird ein Ausführungsbeispiel eines Verfahrens zum Betrieb einer integrierten Halbleiterspeicheranordnung unter Verwendung der erfindungsgemäßen Fuseeinheit(en) bezogen auf die Fig. 2 beschrieben.

Dabei wird angenommen, dass der Chip 1 auf Waferebene mit einer gegenüber dem normalen Betriebsmodus, wie ihn auch der Anwender verwendet, veränderten Funktionalität des Interfaces betrieben wird. Dies wird "veränderter Betriebsmodus" genannt (z.B. Modus 2). Dabei können für die Modi mit unterschiedlichen Funktionalitäten des Interfaces verschiedene Kontaktoren, im allgemeinen Nadelkarten, verwendet werden. Dies kann beispielsweise interessant sein für Double Data Rate (DDR) Chips, die auf Waferebene im Single Data Mode betrieben werden, um die hohe Betriebsfrequenz für DDR zu vermeiden, für eingebaute Self-Test-Lösungen auf dem Chip, um den Chip mit preiswertem Testequipment zu testen, für RAMBUS, der auf Waferebene im DA-Mode getestet wird, allgemein aus Performancegründen, um einen sehr schnellen Halbleiterspeicher auf Waferebene mit kleiner Geschwindigkeit zu testen.

Nach der Erfassung der anliegenden Versorgungsspannung (internes Spannungssignal aktiv), werden die Latches der Fuseeinheiten für die Redundanz und andere Funktionen, die über Fuseeinheiten gesteuert werden, ausgelesen. Zusätzlich zu diesen Fuseeinheiten gibt es die erfindungsgemäße Fuseeinheit, die entscheidet, ob sich der Chip 1 im normalen Betriebsmode oder im veränderten Betriebsmode befindet. Im Zustand nicht durchtrennter Fuseeinheit (Default-Zustand) nimmt der Chip den veränderten Mode an (z.B. Modus 2). Der Wafer (Fig. 2A) kann also sofort mit der veränderten Nadelkarte im Front End getestet werden, ohne ein zusätzliches externes Signal anlegen zu müssen. Nach dem Front End Test wird die Betriebsmodefuseeinheit durchtrennt (Modusfuse-Blow), und der gehäuste Chip 10 kann dann im normalen Mode (z.B. Modus 1) betrieben werden.

Soll der Chip 1 auf Waferebene zu Analysezwecken auch im normalen Mode betrieben werden, kann er durch programmiertes Setzen der Fuseeinheit in den normalen Betriebsmode gebracht werden, ohne dass die Fuseeinheit geschossen werden muss.

Umgekehrt kann nach dem Durchtrennen (Schießen) der Fuseeinheit auch vom normalen Mode durch programmiertes Ansteuern der Fuseeinheit (Fuse Soft Set) wieder in den veränderten Betriebsmode gewechselt werden.

Durch die Verwendung der erfindungsgemäß vorgeschlagenen programmierbaren Betriebsmodusfuseeinheit kann das im Stand der Technik bekannte nachteilige zusätzliche Pad zum Wechseln zwischen den verschiedenen Betriebsmodi vermieden werden.

## Patentansprüche

1. Integrierte Halbleiterschaltung, insbesondere Halbleiterspeicheranordnung, die in verschiedenen Betriebsmodi betreibbar ist und eine Vorrichtung zum Umschalten zwischen diesen Betriebsmodi aufweist, wobei die Umschaltvorrichtung mindestens eine wenigstens im gehäusten Zustand der Halbleiterschaltung durchtrennbare Fuseeinheit aufweist,
**dadurch gekennzeichnet, dass**
die Fuseeinheit eine durch "Fuse Soft Set" programmierbare Fuseeinheit ist, die auch auf Waferebene der integrierten Halbleiterschaltung durchtrennbar ist und bei der durch programmiertes Fuse Soft Set der durchtrennte Zustand überbrückbar ist.

2. Integrierte Halbleiterschaltung nach Anspruch 1,
**dadurch gekennzeichnet, dass**
die Umschaltvorrichtung so eingerichtet ist, dass sie auf ein entsprechend programmiertes Fuse Soft Set ohne Durchtrennen der Fuseeinheit einen dem durchtrennten Zustand derselben entsprechenden Betriebsmodus der Halbleiterschaltung setzt.

3. Integrierte Halbleiterschaltung nach Anspruch 1 oder 2,
**dadurch gekennzeichnet, dass**
die Umschaltvorrichtung so eingerichtet ist, dass die integrierte Halbleiterschaltung auf das Durchtrennen der Fuseeinheit vor der Packung der Halbleiterschaltung in ein Gehäuse in den normalen Betriebsmodus geht.

4. Integrierte Halbleiterschaltung nach einem der vorangehenden Ansprüche,
**dadurch gekennzeichnet, dass**
die Umschaltvorrichtung so eingerichtet ist, dass die integrierte Schaltung im gehäusten Zustand auch im durchtrennten Zustand der Fuseeinheit durch Fuse-Soft-Set-Programmieren derselben zwischen verschiedenen Betriebsmodi wechseln kann.

5. Integrierte Halbleiterschaltung nach einem der vorangehenden Ansprüche,
**dadurch gekennzeichnet, dass**
die Umschaltvorrichtung so eingerichtet ist, dass sie die integrierte Halbleiterschaltung auf Waferebene unmittelbar nach der Fertigung beim Hochfahren der Versorgungsspannung automatisch in einen nicht normalen Betriebsmodus versetzt.

6. Integrierte Halbleiterschaltung nach Anspruch 5,
**dadurch gekennzeichnet, dass**
die Umschaltvorrichtung die Auswahl des nicht normalen Betriebsmodus durch entsprechende Fuse-Soft-Set-Programmierung der Fuseeinheit trifft.

7. Integrierte Halbleiterschaltung nach Anspruch 5,
**dadurch gekennzeichnet, dass**
die Umschaltvorrichtung die Auswahl des nicht normalen Betriebsmodus ohne Fuse-Soft-Set-Programmierung der Fuseeinheit trifft.

8. Integrierte Halbleiterschaltung nach einem der vorangehenden Ansprüche,
**dadurch gekennzeichnet, dass**
die durch Fuse Soft Set programmierbare(n) Fuseeinheit(en) zur Speicherung und zum Auslesen ihrer Information ("default" oder "durchtrennt") eingerichtet ist bzw. sind.

9. Verfahren zum Betrieb einer integrierten Halbleiterspeicheranordnung,
**dadurch gekennzeichnet, dass**
mittels einer mindestens eine durchtrennbare und durch Fuse Soft Set programmierbare Fuseeinheit aufweisenden in der integrierten Halbleiterspeicheranordnung vorgesehenen Umschaltvorrichtung zwischen verschiedenen Betriebsmodi der Halbleiterspeicheranordnung umgeschaltet wird, wobei die Fuseeinheit auf Waferebene durchtrennt wird und auf das Durchtrennen der Fuseeinheit die Halbleiterspeicheranordnung in den normalen Betriebsmodus versetzt wird.

10. Verfahren nach Anspruch 9,
**dadurch gekennzeichnet, dass**
ein weiterer Schritt vorgesehen ist, der die integrierte Halbleiterspeicheranordnung unmittelbar nach der Fertigung beim Hochfahren der Versorgungsspannung automatisch in einen nicht normalen Betriebsmodus versetzt.

11. Verfahren nach Anspruch 10,
**dadurch gekennzeichnet, dass**
die Information der Fuseeinheit gespeichert und unmittelbar nach der "Power-Up-Erfassung" ausgelesen wird.

12. Verfahren nach einem der Ansprüche 9 bis 11,
**dadurch gekennzeichnet, dass**
ein Front-End-Test der integrierten Halbleiterspeicheranordnung im nicht durchtrennten Zustand der Fuseeinheit durchgeführt wird.
